# EUROPÄISCHE PATENTSCHRIFT

(11) **EP 3 514 529 B1**
(45) Veröffentlichungstag und Bekanntmachung des Hinweises auf die Patenterteilung: **15.03.2023**
(21) Anmeldenummer: 19156059.8
(22) Anmeldetag: 12.11.2010
(51) Int. Cl.: G01N 29/04, G01N 29/265, G01N 29/27, G01N 29/275, G01B 7/06, G01B 15/02, G01B 17/02, G01B 21/08, H01L 21/67, G01B 11/24, G01B 11/06, H01L 21/66, G01N 21/95

(54) **MESSEINRICHTUNG ZUR MESSUNG VON SCHICHTDICKEN UND FEHLSTELLEN EINES WAFERSTAPELS**
MEASURING DEVICE FOR MEASURING LAYER THICKNESSES AND DEFECTS IN A WAFER STACK
DISPOSITIF DE MESURE D'EPAISSEURS DE COUCHE ET D'ENDROITS DÉFECTUEUX D'UN EMPILEMENT DE TRANCHES

(43) Veröffentlichungstag der Anmeldung: 24.07.2019
(62) Teilanmeldung aus: 16153569.5
(73) Patentinhaber: EV Group E. Thallner GmbH, 4782 St. Florian am Inn (AT)
(72) Erfinder: WIMPLINGER, Markus, 4910 Ried im Innkreis (AT)
(74) Vertreter: Schneider, Sascha

(56) Entgegenhaltungen:
- CA-A1- 2 314 305
- US-A1- 2010 182 592
- NOEL PODUJE ET AL: "Inspection of Bonded Interfaces Using Scanning Infrared Interferometry", ECS TRANSACTIONS, Bd. 33, 12. Oktober 2010 (2010-10-12), Seiten 537-541, XP055467637, US ISSN: 1938-5862, DOI: 10.1149/1.3483545
- MUSINSKI D: "Displacement-measuring interferometers provide precise metrology", LASER FOCUS W, PENNWELL, TULSA, OK, US, Bd. 39, Nr. 12, 1. Dezember 2003 (2003-12-01), Seiten 80-83, XP009190526, ISSN: 1043-8092
- SCHNELL U ET AL: "DISPERSIVE WHITE-LIGHT INTERFEROMETRY FOR ABSOLUTE DISTANCE MEASUREMENT WITH DIELECTRIC MULTILAYER SYSTEMS ON THE TARGET", OPTICS LETTERS, OPTICAL SOCIETY OF AMERICA, US, Bd. 21, Nr. 7, 1. April 1996 (1996-04-01), Seiten 528-530, XP000559777, ISSN: 0146-9592

## Beschreibung

Die vorliegende Erfindung betrifft eine Messeinrichtung zur Messung und/oder Erfassung von Schichtdicken und Fehlstellen einer oder mehrerer Schichten eines temporär gebondeten Waferstapels an einer Vielzahl von am Waferstapel verteilten Messstellen gemäß Patentanspruch 1.

Der Artikel Noel Poduje ET AL: "Inspection of Bonded Interfaces Using Scanning Infrared Interferometry", ECS Transactions, Bd. 33, 12. Oktober 2010 (2010-10-12), Seiten 537-541, XP055467637, US; ISSN: 1938-5862, DOI: 10.1149/1.3483545 offenbart die Detektion von Leerstellen in gebondeten Waferpaaren. Druckschrift CA 2 314 305 A1 offenbart eine Vorrichtung zur Spektroskopie mit Ultraschall. Der Artikel MUSINSKI D: "Displacement-measuring interferometers provide precise metrology", LASER FOCUS W, PENNWELL, TULSA, OK, US, Bd. 39, Nr. 12, 1. Dezember 2003 (2003-12-01), Seiten 80-83, XP009190526, ISSN: 1043-8092 offenbart ein Interfermeter zur Messung von Fehlstellen. Der Artikel "SCHNELL U ET AL: DISPERSIVE WHITE-LIGHT INTERFEROMETRY FOR ABSOLUTE DISTANCE MEASUREMENT WITH DIELECTRIC MULTILAYER SYSTEMS ON THE TARGET", OPTICS LETTERS, OPTICAL SOCIETY OF AMERICA, US, Bd. 21, Nr. 7, 1. April 1996 (1996-04-01), Seiten 528-538, XP000559777, ISSN: 0146-9592 offenbart ein Verfahren zur interfermetrischen Messung von Abstandsmessungen bei dielektrischen Mehrfachschichtsystem.

Die Entwicklung in der Halbleiterindustrie geht derzeit dahin, dass Wafer Bonding Prozesse zunehmend an Bedeutung gewinnen. So führen beispielsweise neuartige Funktionen wie Bewegungssensoren und / oder Orientierungssensoren in Mobiltelefonen und anderen portablen Geräten wie Spielkonsolen zu einem rasant steigenden Bedarf an Mikro- ElektroMechanischen (MEMS) Komponenten, die Beschleunigung und Drehraten detektieren können.

Ein weiterer Bereich mit rasantem Wachstum sind Bauteile, die als sogenannte 3D ICs gefertigt werden. Darunter versteht man ein Chipsystem, das aus mehren Lagen mit Transistoren ("aktive Lagen") besteht, die untereinander mittels durch das Silizium führenden Kontakten verbunden sind. Diese Durchkontaktierungen werden in der Industrie "Through Silicon Vias" oder kurz "TSVs" genannt.

Um diese TSVs möglichst kostengünstig herstellen zu können, sowie weitere gewünschte Vorteile wie eine kleine Gesamtpackungsgröße realisieren zu können, ist es erforderlich, die Wafer vor oder nach der TSV Herstellung oder im Zuge der TSV Herstellung auf ein geeignetes Maß zu dünnen. Dementsprechend wird heute zwischen sogenannten Via-First-, Via-Middleund Via-Last-Prozessen unterschieden. Hinsichtlich des Dünnens der Wafer stellt sich heraus, dass die angestrebten Zieldicken nicht mehr ausreichen, um den Wafer noch verlässlich von einem Prozessschritt zum nächsten bewegen zu können, da die mechanische Stabilität des Wafers, insbesondere bei den derzeit üblichen 300mm Wafern nicht mehr gegeben ist.

Wafer werden daher mit Vorteil temporär auf einen Träger montiert, damit eine verlässliche Handhabung des dünnen Wafers, welcher üblicherweise eine Dicke <150µm, zumeist jedoch <100µm und vielfach <80 oder sogar <50µm aufweist, gewährleistet wird. Nach dem Fertigstellen der notwendigen Prozessschritte wird der Wafer wieder vom Träger gelöst. Diese beiden Verfahren werden Temporary Bonding und Trennen (Debonding) genannt.

In einem ersten Prozessschritt wird dabei der Produktwafer auf den Träger mittels geeigneter Bonding Technologie, die dem Fachmann bekannt ist, auf den Träger gebondet. Dieser Bondingschritt erfolgt in der Regel so, dass die erste Hauptfläche des Produktwafers, auf welcher die Chipstrukturen aufgebaut sind, so orientiert wird, dass diese Fläche mit dem temporären Kleber in Kontakt kommt, und diese Kleberschicht in weiterer Folge den Kontakt mit dem Trägerwafer herstellt.

In fast allen Fällen erfolgt im Rahmen dieser Rückseitenbearbeitung jedoch ein mechanisches Dünnen des Produktwafers. Dies beinhaltet insbesondere Schleifschritte, bei dem eine definierte Dicke des Produktwafers durch Schleifen entfernt wird. Üblicherweise werden in diesem Zusammenhang einzelne Schleifschritte mit verschiedenen Schleifraten und / oder Körnungen der Schleifscheiben oder Schleifräder verwendet. Meistens gibt es einen ersten Schleifschritt mit einer höheren Materialabtragrate (Grobschleifen) und einen zweiten Schleifschritt mit einer niedrigeren Materialabtragrate (Feinschleifen).

Um die Qualität der finalen Chips, sowie die Integrität des temporär gebondeten Wafers im Zusammenhang mit den Rückseitenprozessschritten sicherzustellen, ist es erforderlich, dass die temporäre Kleberverbindung bestimmte Qualitätskriterien erfüllt. In diesem Zusammenhang gibt es eine Fülle von Anforderungen an das Klebermaterial, welche dem Fachmann bekannt sind. Diese betreffen unter anderem die Fähigkeit des Klebers, bestimmte Prozessbedingungen, die während der Rückseitenbearbeitung auftreten können, tolerieren zu können. Dazu zählen unter anderem Temperaturstabilität, Kompatibilität mit Vakuumumgebung (kein Ausgasen), Stabilität des Klebers gegenüber Chemikalien wie Lösungsmitteln, Säuren und Basen, Kompatibilität mit diversen mechanischen Belastungen oder elektromagnetischen Wellen (zum Beispiel Bestrahlung mit Licht einer bestimmten Wellenlänge) sowie verschiedene Kombinationen aus diesen Parametern. Neben den Anforderungen an das Klebermaterial gibt es auch eine Fülle an Parametern, die die geometrische und mechanische Integrität der Kleberschicht betreffen. Insbesondere ist es für den Erfolg der Rückseitenprozessierung von enormer Bedeutung, dass die Kleberschicht eine genau definierte und wiederholbare Dicke aufweist, sowie keine Fehlstellen (englisch "Voids") aufweist.

Im Gegensatz zum Dünnen eines einzelnen Wafers befindet sich jedoch im Falle eines temporär gebondeten Wafers der Trägerwafer und die Kleberschicht zwischen der Waferauflage und dem Schleifmittel (Schleifrad, Schleifscheibe, etc.). Damit gehen nun die Dicke des Trägerwafers und der Kleberschicht mit in die Gleichmäßigkeit des finalen, gedünnten Produktwafers ein.

Es kann daher zusammengefasst gesagt werden, dass es notwendig ist, die Dickengleichmäßigkeit der Kleberschicht und zumeist auch den absoluten Dickenwert in einem Fertigungsprozess genau steuern und kontrollieren zu können. Für bestimmte Fälle - abhängig von der Steuerung des Schleifprozesses kann es auch notwendig sein, die Dicke des Trägerwafers - unter Umständen auch des gesamten, temporär gebondeten Stapels - zu kennen. Auf jeden Fall ist es aber notwendig, eine entsprechende Qualität der Kleberschicht hinsichtlich Dickengleichmäßigkeit und gegebenenfalls dem absoluten Dickenwert zu gewährleisten.

Hinsichtlich der Fehlstellen gilt, dass diese während einem Schleifprozess und einem etwaigen, darauf folgenden Polierprozess dazu führen würden, dass der Wafer unzureichend mechanisch unterstützt wird, und es dadurch zu Beschädigungen des Wafers oder zumindest Ungleichmäßigkeiten der beim Dünnen angestrebten Waferdicke kommen kann. Diese Ungleichmäßigkeit ist durch die mechanische Flexibilität der Unterlage verursacht, die durch diese Fehlstellen entsteht. In anderen Worten würde sich der Wafer beispielsweise während dem Schleifen in diese Fehlstellen biegen/durchwölben und somit an diesen Stellen ein weniger starker Abtrag erfolgen, was in weiterer Folge in einer lokal erhöhten Dicke des gedünnten Wafers resultieren würde. Dieser Effekt würde sich umso stärker auswirken, je geringer die Zieldicke des gedünnten Wafers ist, da dieser mit abnehmender Dicke flexibler wird. Dies kann letzten Endes sogar zum Bruch des Wafers während dem Dünnen führen. Derartige Bruchereignisse stellen eine große Gefahr für Schleif- und / oder Polierprozesse dar, da die dabei entstehenden relativ großen Materialstücke weitere Beschädigungen des gesamten Wafers, aber auch des Schleifrades / der Schleifscheibe und /oder der Poliervorrichtung nach sich ziehen können. Abgesehen von derartigen Problemen während dem Schleifen und / oder Polieren können derartige Fehlstellen auch zu Fehlern während der restlichen Rückseitenprozessschritte führen. Es sei hier nur als Beispiel angeführt, dass, in derartige Fehlstellen eingeschlossene Gase während Prozessschritten, welche in Vakuumkammern stattfinden, dazu führen können, dass der gedünnte Siliziumwafer während solchen Prozessschritten an diesen Stellen aufplatzt. Dies hätte neben dem Verlust des an dieser Stelle befindlichen Chips auch weitere Probleme zur Folge, da die dabei entstehenden Partikel die verwendete Anlage, in der das Aufplatzen stattfand, sowie unter Umständen andere Fertigungsanlagen kontaminieren würden und eventuell auch Qualitätsprobleme an weiteren, auf diesen Anlage prozessierten Wafern nach sich ziehen würden.

Aufgabe der vorliegenden Erfindung ist es daher, Qualitätskriterien wie Fehlstellenfreiheit, Wiederholbarkeit und Gleichmäßigkeit der Kleberdicke zu optimieren und möglichst wenig Ausschuss bei der Herstellung beziehungsweise Bearbeitung von temporär gebondeten Waferstapeln zu gewährleisten.

Diese Aufgabe wird mit den Merkmalen des Patentanspruchs 1 gelöst. Vorteilhafte Weiterbildungen der Erfindung sind in den Unteransprüchen angegeben. Die Ausführungsformen, in denen die Messung mittels Ultraschall ausgeführt wird, fallen nicht unter den Anspruchsgegenstand.

Grundgedanke der vorliegenden Erfindung ist es zum einen, bei der Bearbeitung von Wafern Abweichungen bezogen auf die obengenannten Qualitätskriterien zu einem frühest möglichen Zeitpunkt zu erkennen, um einen etwaigen Verlust von Produktwafern schon aus diesem Grund möglichst gering zu halten. Dies kann insbesondere dadurch gewährleistet werden, dass die Schichtdicke und/oder Fehlstellen einzelner Schichten des Waferstapels gemessen/erfasst werden, und zwar insbesondere zeitnahe bevor der Waferstapel geschliffen wird. Besonders wichtig ist es dabei, die geometrischen Parameter des Trägerwafers zu überwachen, da dieser der mechanischen Unterstützung des Produktwafers dient und während des Schleifprozesses zwischen der Waferauflage, die als Referenzebene oder Referenzfläche dienen kann, und dem Schleifmittel zu liegen kommt. Zeitnahe im vorgenannten Sinne bedeutet, dass in der Verarbeitungskette von Waferstapeln möglichst wenig Waferstapel in der Verarbeitungskette vor dem genannten Waferstapel, also zwischen dem Messschritt/Erfassungsschritt und einschließlich dem Schleifschritt sind, insbesondere maximal fünf, vorzugsweise maximal drei, noch bevorzugter maximal einer. Dabei kann es erfindungsgemäß vorgesehen sein, dass der Messschritt/Erfassungsschritt in einem Mess-/Erfassungsmodul (auch metrology-Modul) und der Schleifschritt räumlich getrennt in einem, insbesondere benachbarten, Schleifmodul ausgeführt werden. Der Messschritt/Erfassungsschritt und der Schleifschritt erfolgen erfindungsgemäß in-line. Es kann durchaus auch sein, dass die Untersuchung des Waferstapels abgeschlossen wurde, bevor der vorherige Wafer fertig geschliffen wurde, sich also noch im Schleifmodul befindet. Der gemessene Waferstapel muss dann "warten", bis er vorrücken kann.

In einer besonders vorteilhaften Ausführungsform erfolgt der Messschritt / Erfassungsschritt zeitnahe zum Temporary Bonding Schritt. Dadurch wird erreicht, dass im Falle von, beim Temporary Bonding Schritt auftretenden Fehlern, die Menge des fehlprozessierten Materials reduziert wird. Dies bietet den Vorteil, dass die Materialmenge, insbesondere die Anzahl der gebondeten Waferstapel, die einer Nachbearbeitung ("Rework") zugeführt werden müssen, reduziert werden kann, was ökonomische und logistische Vorteile mit sich bringt. Unter zeitnahe ist in diesem Zusammenhang zu verstehen, dass die Messung auf jeden Fall vor dem Schleifen der Wafer stattfindet. Wie bereits ausgeführt, stellt der Schleifprozess einen nicht reversiblen Prozess dar, der zu einem katastrophalen Fehler und insbesondere zu einem Totalverlust einzelner, gebondeter Waferstapel führen kann. Mit Vorteil bedeutet zeitnahe jedoch, dass maximal 10 weitere Waferstapel gebondet wurden bevor die Inspektion eines gegebenen Waferstapels erfolgt ist. Noch besser ist es, wenn diese Zahl auf weniger als 7 oder noch besser 5 oder 3 reduziert werden kann. Diese Zahlen beziehen sich auf einen Prozessablauf, in dem alle gebondeten Waferstapel nach dem Temporary Bonding Prozess, insbesondere unmittelbar nach dem Temporary Bonding Schritt dem erfindungsgemäßen Messschritt / Erfassungsschritt zugeführt werden. Diese soeben beschriebene Reduktion dieser Waferstapel, die im Prozessablauf auf den Inspektionsschritt warten lässt sich mit Vorteil mittels einer Konfiguration der Fertigungsumgebung erreichen, bei der die, den Temporary Bonding Schritt ausführende Vorrichtung räumlich möglichst nahe zur erfindungsgemäßen Messvorrichtung angeordnet ist. Insbesondere lässt sich das dadurch erreichen, die Messvorrichtung in ein Temporary Bonding Gerät zu integrieren. Eine derartige, integrierte Lösung wird in der Industrie üblicherweise als in-line Integration bzw. in-line Metrologie bezeichnet. Dies kann gemäß der vorliegenden Erfindung in Kombination mit jeglichen, aus dem Stand der Technik bekannten Temporary Bonding Lösungen realisiert werden. Beispielsweise ist es erfindungsgemäß denkbar, die Messvorrichtung in eine Temporary Bonding Anlage für thermoplastische oder UV-aushärtbare Kleber zu integrieren, wobei derartige Anlagen üblicherweise ein oder mehrere Beschichtungsmodule für das Aufbringen des Klebers sowie eine oder mehrere Bondmodule beinhalten, zwischen denen die, zu bearbeitenden Wafer mittels einer automatischen Wafer Handhabungsvorrichtung, die insbesondere Teil der Anlage ist, bewegt werden. Je nach verwendeter Kleberart können zusätzlich auch noch Heizmodule im System integriert sein, die zum Austreiben des Lösungsmittels aus der Kleberschicht dienen. Mit Vorteil ist es auch üblich, geeignete, dem Fachmann bekannte Justagevorrichtungen zum Ausrichten der Wafer in derartige Anlagen zu integrieren.

Daneben besteht ein Grundgedanke der Erfindung darin, Fehlstellen in der Kleberschicht sowie die Kleberschichtdicke und etwaige Schwankungen dieser Kleberschichtdicke zu erfassen.

Ein weiterer Aspekt der Erfindung besteht darin, dass die erfassten Werte als Daten automatisch auswertbar sind, um automatisiert eine Entscheidung über ein Weiterprozessieren oder ein Entfernen des Wafers aus der Prozesskette zu fällen.

Ein weiterer, zentraler Aspekt der Erfindung besteht darin, den Erfindungsgegenstand in ein automatisches Bearbeitungsgerät für das temporäre Bonden von Produktwafern zu integrieren. Auf diese Weise soll eine möglichst vollständige Analyse eines jeden Produktwafers ermöglicht werden, ohne die Produktivitätsrate des Bearbeitungsgerätes zu verringern. Die Erfassung/Messung erfolgt damit "in-line", also als "in-line-Metrologie". Entsprechend ist gemäß einer Ausführungsform der erfindungsgemäßen Messeinrichtung vorgesehen, dass diese in einer Waferbearbeitungsanlage, insbesondere in-line einsetzbar ist.

Dabei ist erfindungsgegenständlich ein modulartiger Aufbau der in-line für den Prozessablauf beziehungsweise die Prozesskette angeordneten Prozessmodule vorgesehen. Besonders vorteilhaft ist die Anwendung im Zusammenhang mit folgenden Modulen in einer Waferbearbeitungsanlage:
- einem Belackungsmodul zur zumindest teilweisen Belackung des Waferstapels insbesondere mit einem Kleber, mit Vorteil einem temporären Kleber,
- einem bond-Modul zum Verbinden der Waferschichten des Waferstapels,
- einer erfindungsgemäßen Messeinrichtung in einem Inspektionsmodul,
- einer Handhabungseinrichtung, insbesondere mit einem oder mehreren Roboterarmen, zur transportieren jedes Waferstapels innerhalb der Waferbearbeitungsanlage von einem Modul zum nächsten und
- optional, einem Heizmittel zum Austreiben von Lösungsmittel.

Falls Abweichungen in diesem Zusammenhang insbesondere vor dem Rückdünnen des Produktwafers detektiert werden, ist es möglich, den Produktwafer beziehungsweise den Waferstapel einer Nachbesserung (englisch: "Rework") zu unterziehen. Dies stellt sich insbesondere so dar, dass der Produktwafer noch einmal vom Träger gelöst werden würde, und der gesamte Temporary Bonding Prozess noch einmal neu durchgeführt werden könnte. Für diesen Löseschritt können dafür eigens vorgesehene Anlagen oder in-line-Module verwendet werden. Insbesondere eignen sich dafür die Debonding Anlagen, die üblicherweise zum Ablösen des dünnen Produktwafers vom Träger verwendet werden. Gegebenfalls sind dazu bestimmte Prozessparameter für diese Debonding Anlage an die Erfordernisse des Debondens eines nicht gedünnten oder nicht vollständig gedünnten Produktwafers anzupassen. Dieser Rework Prozess ist im Sinne einer kosteneffizienten Fertigung von großer Bedeutung. Insbesondere Produktwafer oder Waferstapel, die einen sehr hohen Grad an Komplexität aufweisen, was für derartige 3D IC Waferstapel zu erwarten ist, haben in diesem Stadium einen sehr beträchtlichen Wert, da sie bereits weit im Fertigungsfluss fortgeschritten sind. Der Wert solcher Waferstapel übersteigt meist 1.000 Euro, teilweise sogar 10.000 Euro. Daher ist es erfindungsgemäß entscheidend, sogenannte katastrophale Fehler, die zu einem Totalverlust des Waferstapels führen würden, rechtzeitig beziehungsweise möglichst frühzeitig zu erkennen und diesen einem Rework Prozess zuzuführen, bevor die Waferstapel einen Prozessschritt durchlaufen, nach dem dieser Rework Prozess nicht mehr möglich wäre. In diesem Zusammenhang kann das Schleifen des Waferstapels zur Dickenreduktion auf jeden Fall als ein Schritt angesehen werden, nach dem ein derartiger Rework Prozess nicht mehr möglich wäre und im Umkehrschluss ein Totalverlust des Produktwafers drohen würde.

Gemäß einer vorteilhaften Ausführungsform der Erfindung ist vorgesehen, dass die Messeinrichtung, insbesondere der Sender und der Empfänger, gleichzeitig zur Erfassung der Schichtdicken und Fehlstellen, insbesondere mit einer Schichtenauflösung < 10µm, vorzugsweise < 1 µm, noch bevorzugter < 0,1 µm, einsetzbar ist. Erfindungsgemäß ist es außerdem denkbar, mehrere Sender/Empfänger-Einheiten gleichzeitig, insbesondere nebeneinander angeordnet, einzusetzen, um die Oberfläche entsprechend schneller abrastern zu können. Die Schichtenauflösung ist in Querrichtung zur Referenzebene R gemeint, also eine Tiefenauflösung beziehungsweise vertikale Auflösung beziehungsweise Dickenauflösung.

Der Durchmesser D des Messsignals liegt mit Vorteil zwischen 1 µm und 100µm, insbesondere zwischen 5µm und 50µm, vorzugsweise zwischen 10µm und 30µm. Bei einem Laserstrahl entspricht der obige Durchmesser D beispielsweise dem Durchmesser des Laserstrahls.

In einer weiteren vorteilhaften Ausführungsform der Erfindung ist vorgesehen, dass mittels der Messeinrichtung benachbarte Messstellen innerhalb eines Rasters R mit einem Abstand X bzw. Y von weniger als 5mm, vorzugsweise weniger als 3mm, noch bevorzugter weniger als 1mm, am bevorzugtesten weniger 0,5mm, messbar sind. Es erfolgt also eine flächendeckende, rasterartige Erfassung des gesamten Waferstapels, so dass praktisch alle Fehlstellen möglichst lückenlos erfasst werden können.

Eine Breitenauflösung des Messsignals in lateraler Richtung, also parallel zur Referenzebene R liegt mit Vorteil zwischen 0,1µm und 50µm, insbesondere zwischen 1µm und 30µm, vorzugsweise zwischen 10µm und 20µm. Ein Laserstrahl soll beispielsweise an einer bestimmten Messstelle messen. Er wird die Messstelle aber nicht genau treffen, sondern um deltaX/deltaY abweichen. deltaX und deltaY entspricht dabei der Breitenauflösung. Mit der Breitenauflösung wird insbesondere die Ausdehnung, also Breite oder Durchmesser einer Fehlstelle erfasst. Je besser die Breitenauflösung, desto mehr Messungen müssen durchgeführt werden. Es ist daher möglichst ein Optimum zwischen schneller Messung und Erfassung möglichst aller Fehlstellen einzustellen. Je dünner die Zieldicke des Wafers beziehungsweise Waferstapels ist, desto kritischer sind bereits kleine Fehlstellen.

Gemäß einer bevorzugten Ausführungsform der Erfindung ist vorgesehen, dass die Messung/Erfassung zweistufig, insbesondere durch eine erste schnelle und grobe Messeinrichtung und eine optionale zweite, sehr präzise Messeinrichtung. Die zweite Messeinrichtung durchlaufen nur Waferstapel, die in der ersten Messeinrichtung als möglicherweise kritisch eingestuft worden sind. Die zweite Messeinrichtung ist nicht in-line vorgesehen, damit der Prozessfluss möglichst nicht gestört wird. Ein von der Auswerteeinheit als möglicherweise in der ersten Messeinrichtung als kritisch eingestufter Waferstapel wird also aus dem Prozessablauf zumindest zeitweise ausgegliedert.

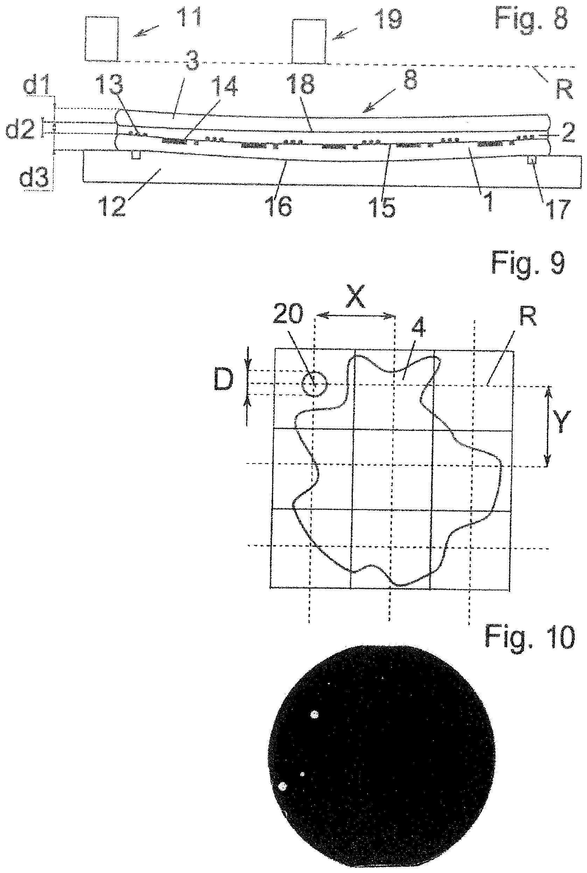

Der Zusammenhang zwischen dem Punktrasterabstand, dem Durchmesser D des Messsignals und der Breitenauflösung ist in Fig. 9 dargestellt.

Die vorgestellte Methode kann in-situ und/oder in-line verwendet werden. Unter in-situ versteht man die Anwendung der Methode während eines technologischen / physikalischen / chemischen Verarbeitungsschritts. Genannt seien hierbei etwa das Rückdünnen eines Strukturwafers, oder das Randzonenätzen in einem chemischen Bad.

Unter in-line versteht man die Anwendung des Verfahrens in einem Prozessmodul, welches einem anderen Prozessmodul vorgelagert beziehungsweise nachgelagert ist. Das erste Modul kann bei einer erfindungsgemäßen Ausführungsform eine Bonding Station sein. Das nachfolgende Modul wäre dann in diesem Fall in einer typischen Ausführungsform die hier vorgestellte Messeinrichtung, um einen Waferstapel zu vermessen. Während in der Bonding Station ein Waferstapel gebondet wird, wird in der Messstation einer der zuvor gebondeten Waferstapel, mit Vorteil ein möglichst zeitnahe zuvor gebondeter Waferstapel gemäß obenstehenden Erläuterungen für den Begriff zeitnahe, insbesondere ein unmittelbar zuvor gebondeter Waferstapel vermessen / erfasst. in-line unterscheidet sich daher von in-situ dadurch, dass eine Trennung des Verfahrens in ein eigenes Modul erfolgt, welches aber in eine Verarbeitungskette mit weiteren Bearbeitungsschritten systemintegriert wurde

Die erfindungsgemäße Messeinrichtung ist mit einem, insbesondere mit dem Sender und dem Empfänger mechanisch gekoppelten, vorzugsweise fixierten, Weißlichtinterferometer zur Messung dessen Abstands zu einer Oberfläche an mindestens einer der Messstellen versehen.

Weitere Vorteile, Merkmale und Einzelheiten der Erfindung ergeben sich aus der Beschreibung bevorzugter Ausführungsbeispiele sowie anhand der Zeichnungen. Diese zeigen in:
- Fig. 1:: eine erfindungsgemäße Messeinrichtung in einer ersten Ausführungsform,
- Fig. 2:: eine erfindungsgemäße Messeinrichtung in einer zweiten Ausführungsform
- Fig. 3:: eine Messeinrichtung außerhalb des Schutzumfangs der Ansprüche,
- Fig. 4:: eine Messeinrichtung außerhalb des Schutzumfangs der Ansprüche,
- Fig. 5:: eine Veranschaulichung von möglichen Qualitätsmängeln eines Waferstapels,
- Fig. 6a - 6c:: verschiedene Verfahrensabläufe zur Messung/Erfassung mehrere Messstellen,
- Fig. 7a:: eine Aufnahme eines durch Infrarotsignale mit der erfindungsgemäßen Messeinrichtung erfassten Waferstapels,
- Fig. 7b:: ein Diagramm einer erfindungsgemäßen Vermessung/Erfassung einer Waferoberfläche,
- Fig. 8:: eine schematische Darstellung einer Vorrichtung zur Bearbeitung eines Waferstapels,
- Fig. 9:: eine schematische Darstellung der Erfassung einer Fehlstelle eines Waferstapels,
- Fig. 10:: eine Aufnahme eines durch Ultraschallsignale mit einer nicht erfindungsgemäßen Messeinrichtung erfassten Waferstapels,
- Fig. 11:: eine schematische Darstellung einer Vorrichtung zur Bearbeitung eines Waferstapels und
- Fig. 12:: eine erfindungsgemäße Messeinrichtung in einer fünften Ausführungsform.

In den Figuren sind gleiche oder gleichwirkende Bauteile mit den gleichen Bezugszeichen gekennzeichnet.

In Figur 8 ist eine Waferbearbeitungsvorrichtung zur Bearbeitung eines Waferstapels 8 abgebildet, der aus einem Strukturwafer 1, einer Verbindungsschicht 2 und einem Wafer 3 besteht. Der Strukturwafer 1 weist an einem Übergang 15 zwischen dem Strukturwafer 1 und der Verbindungsschicht 2 in die Oberfläche des Strukturwafers 1 eingebrachte Kontakte 14 sowie aus der Oberfläche hervortretende Bumps 13 auf, die aus Metalllegierungen bestehen können. Der Strukturwafer 1 kann auch ohne Strukturen ausgebildet sein, ebenso wie der Wafer 3 mit Strukturen ausgebildet sein kann.

Der Waferstapel 8 ist seiner der Oberfläche des Strukturwafers 1 gegenüberliegenden Flachseite auf einer Aufnahmefläche 16 einer Aufnahme 12, hier ein Chuck, fixiert. Die Fixierung erfolgt über Vakuumbahnen 17 der Aufnahme 12.

Die Verbindungsschicht 2 ist als temporärer Kleber ausgebildet und mittels dieser ist der Strukturwafer 1 an den Wafer 3 temporär gebondet. Ein weiterer Übergang 18 liegt entsprechend zwischen der Verbindungsschicht 2 und dem Wafer 3.

Die Vorrichtung weist weiterhin eine Messeinrichtung 11 auf, die gegenüber dem Waferstapel 8 entlang einer Referenzebene R beweglich ist. Entscheidend ist die Ausführung einer Relativbewegung, so dass eine Bewegung des Waferstapels 8, insbesondere durch Bewegung der Aufnahme 12, ebenso denkbar ist. Entscheidend ist dabei, dass die Relativbewegung zwischen der Messeinrichtung 11 und dem Waferstapel 8 erfassbar ist, beispielsweise in einem die Referenzebene R aufspannenden X-Y-Koordinatensystem.

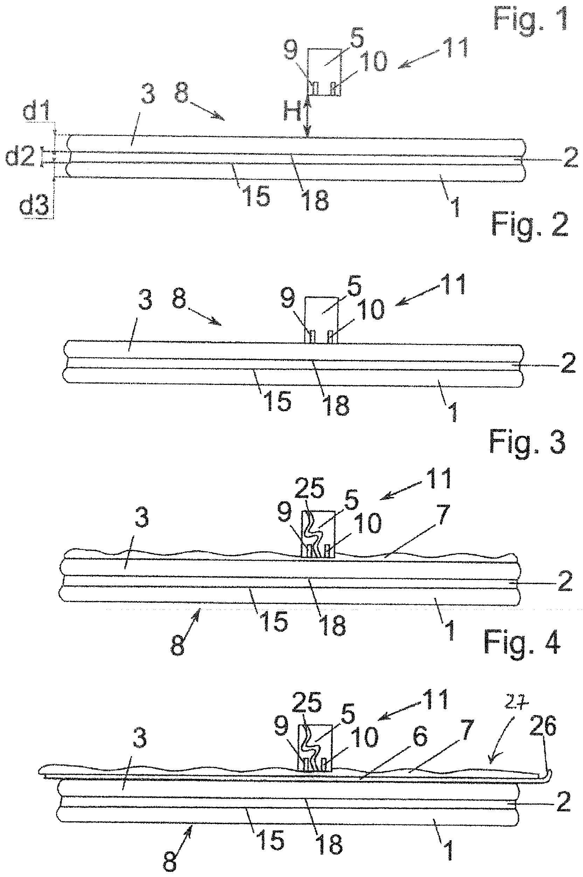

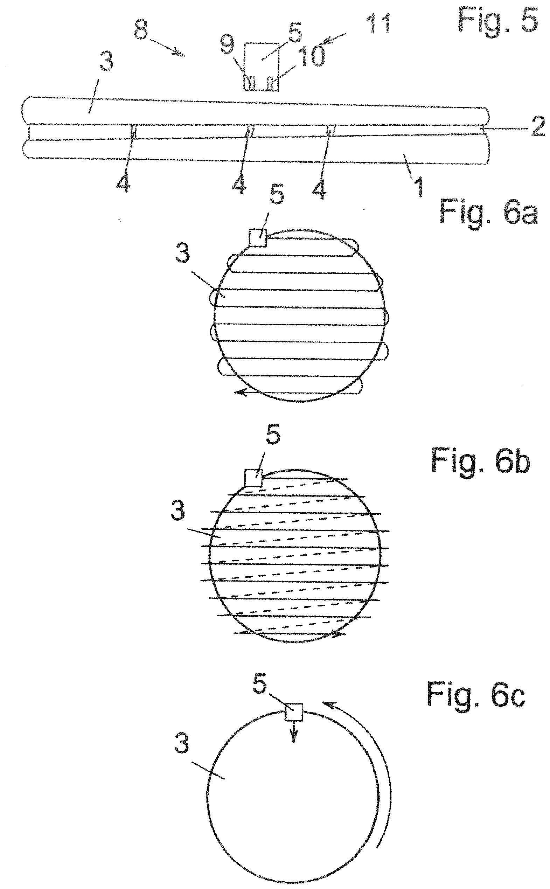

Die Funktion der Messeinrichtung 11 ist in verschiedenen Ausführungen in den Figuren 1 bis 4 dargestellt. Die Figur 5 zeigt die möglichen Probleme, die sich beim Verbinden von Wafern ergeben können. Beispielsweise kann die Verbindungsschicht 2 eine inhomogene Schichtdicke besitzen. Im Idealfall wären die Wafer 1, 3 überall gleich dick. Figur 5 zeigt, dass auch die Wafer 1, 3 eine inhomogene Dickenverteilung besitzen können. Weiterhin können die Wafer Fehlstellen 4, sogenannte "Voids", aufweisen.

Gemäß Figur 1 besteht die Messeinrichtung 11 aus einem Gehäuse 5, in welchem an dessen Unterseite ein Sender 9 und ein Empfänger 10 angeordnet sind. Diese sind in Richtung des Waferstapels 8 ausgerichtet, insbesondere parallel zu der Referenzebene R. Die Messung basiert darauf, dass Wellen in den gebondeten Waferstapel 8 mittels des Senders 9 eingekoppelt werden und die Reflektionen an den einzelnen Übergängen 15, 18 zwischen den verschiedenen Materialien mit dem Empfänger 10 erfasst werden. Der Empfänger 10 ist als Signaldetektor zur Detektion der Signale in Form von elektromagnetischen Wellen ausgebildet.

Als Signalwellen eignen sich insbesondere elektromagnetische Wellen mit einer geeigneten Wellenlänge, bei der eine ausreichende Transparenz der verwendeten Wafer 1, 3 und des Klebermaterials der Verbindungsschicht 2 vorhanden ist. Für Siliziumwafer kann dies beispielsweise Licht im Infrarotbereich oder Röntgenstrahlung sein. Für Glaswafer würde sich Licht im sichtbaren Bereich und bei Verwendung geeigneter Gläser auch im UV-Bereich eignen.

Die Signalquelle für die elektromagnetische Strahlung kann insbesondere in dem Gehäuse 5 angeordnet sein, insbesondere im Sender 9 integriert. Alternativ zu elektromagnetischen Wellen eignen sich Schallwellen, insbesondere Wellen im Ultraschallbereich von 100 KHz bis 800 MHz, mit Vorzug 100 MHz bis 400 MHz.

Bevorzugt ist die Verwendung einer Lichtquelle mit elektromagnetischer Strahlung im Infrarotbereich, insbesondere 1050nm bis 10µm, vorzugsweise 1300nm Lichtwellenlänge. Die Optik der Messeinrichtung ist dabei so konzipiert, dass der Strahl elektromagnetischer Wellen fokussiert und auf den Waferstapel 8 geleitet werden kann.

Soweit sich der Sender 9 und der Empfänger 10 beziehungsweise das Gehäuse 5, wie bei den Ausführungsformen gemäß Figuren 2, 3 und 4 in direktem Kontakt mit dem Waferstapel 8 beziehungsweise einer auf dem Waferstapel 8 aufgebrachten Flüssigkeit 7 befinden, erfolgt die Messung/Erfassung durch Kontakteinkopplung. Diese Art der Kontakteinkopplung erfolgt vor allem bei der Verwendung von Ultraschallwellen.

Bei der Verwendung von elektromagnetischen Wellen ist ein Abstand H zwischen der Sender-Empfänger-Einheit und dem Waferstapel 8 vorgesehen.

Im Falle der in Figur 3 gezeigten , nicht erfindungsmäßigen Ultraschallmessung mittels der Flüssigkeit 7 wird diese vor der Messung auf den Waferstapel 8 aufgebracht und das Gehäuse 5 mit dem Ultraschallgeber taucht in die Flüssigkeit 7, um die Ultraschallwellen auf den Waferstapel 8 zu übertragen und eine Messung durch den Sender 9 und den Empfänger 10 zu ermöglichen. Der Sender 9 kann dabei als der Ultraschallgeber ausgebildet sein. Das Aufbringen der Flüssigkeit 7 erfolgt regelmäßig durch das Gehäuse 5 selbst. Das Gehäuse 5 besitzt eine Zuleitung 25, über welche der, insbesondere kontinuierliche, Zufluss der Flüssigkeit 7 von einem Flüssigkeitsreservoir erfolgt.

In der nicht erfindungsmäßigen Ausführungsform gemäß Figur 4 ist darüber hinaus vorgesehen, dass zwischen der Flüssigkeit 7 und dem Waferstapel 8 eine Membran 6 vorgesehen ist, um den Waferstapel 8 vor der Flüssigkeit 7 zu schützen. Die Membran 6 ist so elastisch, dass sie sich an die Topografie der Oberfläche des Waferstapels 8 anpassen kann. Auf der Oberfläche der Membran 6 wird die Flüssigkeit 7 aufgebracht. Die Einkopplung des Messsignals erfolgt dann durch die Flüssigkeit 7 sowie durch die Membran 6 hindurch in den Waferstapel 8. Der Raum unterhalb der Membran 6 ist vorzugsweise evakuierbar und wird evakuiert, bevor die Messung erfolgt. Die Evakuierung hat den Vorteil, dass der Luftdruck auf der Seite des Gehäuses 5 die Membran 6 auf die Oberfläche des Wafers 3 drückt. Dadurch wird gewährleistet, dass die Membrane die Oberfläche des Wafers 3 ohne Bildung von Hohlräumen bedeckt und dadurch eine Signaleinkopllung nur über Festkörper und/oder Flüssigkeiten, insbesondere ohne Gasphase, erfolgt.

In einer besonders vorteilhaften Variante der Ausführungsform gemäß Figur 4 dient die Membrane 6 als Flüssigkeitsspeicher, indem durch eine umlaufende Membranwand 26 ein wannenförmiges Flüssigkeitsreservoir 27 gebildet wird. In dieser besonderen Ausführungsform ist es daher erfindungsgemäß denkbar, dass ein geschlossener Kreislauf zwischen dem Flüssigkeitsreservoir 27 und der Zuleitung 25 vorgesehen ist. Dadurch ist eine sehr saubere Umsetzung der Messung/Erfassung möglich.

In einer besonders bevorzugten Ausführungsform ist es auch denkbar, dass die Vorrichtung hinsichtlich der Flüssigkeitshandhabung lediglich das wannenförmige Flüssigkeitsreservoir 27 beinhaltet und auf einen Kreislauf für die Flüssigkeit gänzlich, insbesondere zumindest während dem Messvorgang, verzichtet. Die Zufuhr und der gegebenenfalls, insbesondere zur Erleichterung von Wartungsarbeiten, vorgesehene Ablauf der Flüssigkeit zu / aus dem Flüssigkeitsreservoir 27 erfolgt in diesem Fall durch geeignete, in den Figuren nicht dargestellte Mittel zur Flüssigkeitszufuhr und Flüssigkeitsableitung.

Die an den Übergängen 15, 18 und an der Aufnahmefläche 16 reflektierten Signale in Form von elektromagnetischen Wellen werden mittels eines jeweils geeigneten Empfängers 10 ausgewertet und lassen unter Berücksichtigung der Ausbreitungsgeschwindigkeit der Wellen in den verschiedenen Materialien des Strukturwafers 1, der Verbindungsschicht 2 und des Wafers 3 einen präzisen Rückschluss auf die Materialdicken d1 des Wafers 3 beziehungsweise d2 der Verbindungsschicht 2 und d3 des Strukturwafers 1 zu. Somit ist eine präzise Erfassung der Dicken und der Dickengleichmäßigkeit der Schichten des Waferstapels 8, also des Strukturwafers 1, der Verbindungsschicht 2 und des Wafers 3 möglich. Durch die Bewegung der Messeinrichtung über den gesamten Waferstapel 8 parallel beziehungsweise entlang der Referenzebene R können die Schichtdicken an entsprechenden Messstellen ortsaufgelöst bestimmt werden.

Wie oben beschrieben erfolgt zur Messung/Erfassung des Waferstapels 8 eine Bewegung relativ zu dem Sender 9 und dem Empfänger 10. Dies kann entweder durch Bewegen des Waferstapels 8 oder der Sender-Empfänger-Einheit oder eine Kombination der beiden Bewegungsmöglichkeiten erreicht werden. Vorzugsweise wird eine Anordnung gewählt, bei der möglichst wenig Achsen benötigt werden, insbesondere durch eine Verfahreinrichtung für die Bewegung des Waferstapels entlang einer X- und einer Y-Achse, also parallel zu der Referenzebene R. Die Messeinrichtung wird vorzugsweise starr montiert.

In den Figuren 6a bis 6c sind die wichtigsten Rastermethoden zur Erfassung des gesamten Waferstapels 8 dargestellt, wobei in Figur 6a mäanderförmig erfasst wird. Mäanderförmige Scans haben den Vorteil, dass ein sehr zügiges Abfahren der Erfassungsstrecke erfolgen kann. sich negativ auf die Aufzeichnung auswirkt. Eine weitere Scanart stellt ein Linienscan gemäß Figur 6b dar. Diese Scanart ist durch einen Linearantrieb realisierbar, wobei ein mögliches Spiel von Translationseinheiten des Linearantriebs, insbesondere ein Umkehrspiel, minimiert wird. Diese Variante ist insbesondere bei dem oben beschriebenen zweistufigen Messverfahren besonders vorteilhaft, insbesondere in der zweiten Messeinrichtung. Eine weitere Alternative besteht in einem konstanten Vorschub des Gehäuses 5 bei rotierendem Waferstapel 8 zum Zentrum des Waferstapels 8 hin. Hieraus ergibt sich eine spiralförmige Erfassung. Den vorgenannten Rastermethoden ist gemein, dass die Rasterung kontinuierlich erfolgt. Die kontinuierlichen Messsignale der einzelnen Messstellen werden durch eine Auswerteeinheit entsprechend umgerechnet und ausgewertet. Die Zeit zum Scannen eines Waferstapels, insbesondere für in-line integrierte, erfindungsgemäße Messeinrichtungen beträgt weniger als 180 Sekunden, vorzugsweise weniger als 100 Sekunden, noch bevorzugter weniger als 60 Sekunden. Für nicht in-line integrierte, insbesondere zusätzlich zu einer in-line integrierten Messeinrichtung vorgesehene, Messeinrichtungen, insbesondere Messeinrichtungen, die zum detaillierten Inspizieren von, insbesondere ausgegliederten, Waferstapeln mit hoher Auflösung dienen, können die Inspektionszeiten auch erheblich länger sein. Es ist durchaus denkbar, dass derartige Messvorgänge länger als 10min, in vielen Fällen auch länger als 20min oder 30min dauern.

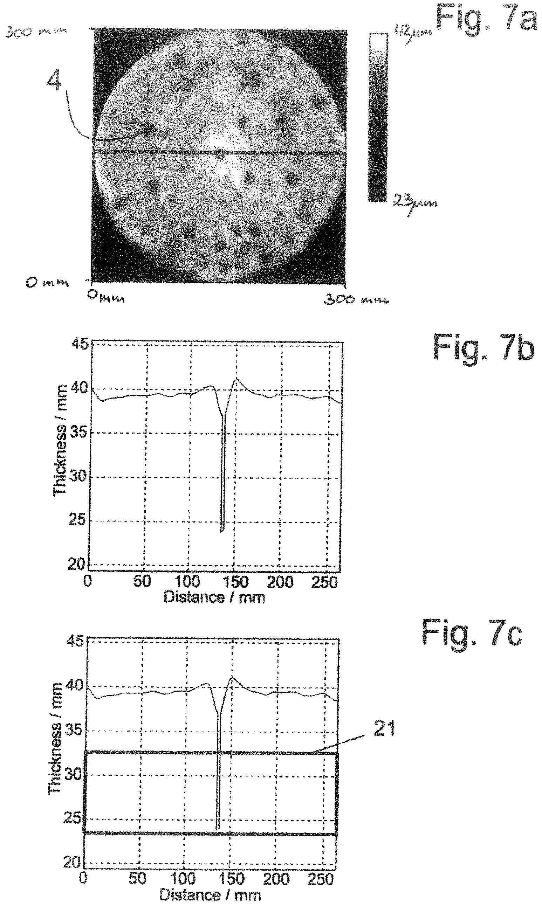

Befinden sich nun Fehlstellen 4 in der Kleberschicht 2 (Fig. 7a), so ist innerhalb dieser Fehlstelle 4 eine Weiterleitung der eingekoppelten Welle entweder gar nicht oder nur mit einer unterschiedlichen Ausbreitungsgeschwindigkeit möglich. Im Falle der akustischen Wellen ist deren Ausbreitung in Fehlstellen 4so gut wie gänzlich verhindert, so dass anhand der reflektierten Wellen sehr deutlich auf die Fehlstelle 4 rückgeschlossen werden kann (Fig. 10.).

Im Falle der elektromagnetischen Wellen und insbesondere Infrarotlicht detektiert dass Messgerät die unterschiedlichen Übergänge beziehungsweise Schnittebenen 15, 16, 18 durch Interferenz und kann dadurch auf die Schichtdicken d1, d2, d3 rückschließen. Die Ermittlung der Schichtdicken d1, d2, d3 erfolgt indirekt über das Detektieren von Peaks an den Übergängen 15, 16, 18 durch Interferenz. Auf Grundlage der Differenz dieser Peaks ist die Dicke der jeweiligen Schicht, die von den Übergängen 15, 16, 18 begrenzt wird, berechenbar. Die Auswerteeinheit führt diese Berechnung automatisch durch. Dabei ist zu beachten, dass die gemessene Schichtdicke linear vom Brechungsindex der Schicht abhängig ist. Dies rührt daher, dass sich die elektromagnetischen Wellen in verschiedenen Materialien unterschiedlich schnell ausbreiten, und die Signallaufzeit durch die Schichten die Lage / den Abstand der, vom Empfänger detektierten Peaks linear beeinflusst. In einer bevorzugten Ausführungsform erscheint ohne entsprechender Korrektur die, für eine Schicht gemessene Schichtdicke für Schichten mit höherem Brechungsindex (n) um den Faktor des Brechungsindexes (n) höher.

Beispielsweise wäre die gemessene Schichtdicke für eine Kleberschicht mit einer Dicke d2 im Bereich des Klebers d2 * n, während die gemessene Schichtdicke im Bereich etwaiger, in der Kleberschicht befindlicher Voids d2^{∗}1 betragen würde. Dies basiert auf der Tatsache, dass Luft und Vakuum einen Brechungsindex von annähernd 1 haben. Der Brechungsindex (n) für verschiedene Materialien lässt sich mit Methoden, die dem Fachmann bekannt sind, ermitteln. Üblicherweise sind diese Werte auch von der verwendeten Wellenlänge des elektromagnetischen Signals abhängig. Für IR Licht mit einer Wellenlänge von 1300nm kann der Brechungsindex für gängige thermoplastische Kleber beispielsweise im Bereich zwischen 1,2 und 2,5 zumeist jedoch zwischen 1,3 und 2, noch typischer jedoch zwischen 1,4 und 1,9 liegen.

Die vorbeschriebenen Effekte führen im Messergebnis für die Kleberschichtdicke zu einem abrupten Abfall der gemessenen Schichtdicke (Thickness) (Fig. 7b, Fig. 7c) im Bereich einer Fehlstelle, was einen Rückschluss auf die Fehlstelle 4 mittels geeigneter Auswertealgorithmen zulässt. Die X-Achse der Abbildungen/Diagramme aus Figuren 7a bis 7c stellt den jeweiligen Abstand (distance) zum linken Waferstapelrand dar.

Ein Beispiel der Umsetzung eines Auswertealgorithmus zeigt Fig. 7c. Die Auswerteeinheit ist so ausgelegt, dass ein frei definierbares Fenster einen Überwachungsbereich 21 innerhalb des Messbereichs überwacht. Treten Signale in den Überwachungsbereich 21 ein, wird eine entsprechende Aktion gesetzt. Dies sei anhand eines Beispiels erklärt. Figur 7c stellt die Schichtdicke d2 (thickness) der Verbindungsschicht 2 als Funktion des Abstandes (distance) entlang des Waferstapels 8 dar. Offensichtlich variiert die Schichtdicke der Verbindungsschicht 2 im dargestellten Beispiel zwischen 37 und 42 µm. Dieser Dickenwert repräsentiert in diesem Fall den, für die Kleberdicke gemessenen Wert ohne Korrektur durch den Brechungsindex. Das heißt, die reelle Kleberdicke würde sich in diesem Fall durch Division des dargestellten Dickenwertes durch den Brechungsindex errechnen lassen. In speziellen Ausführungsformen kann zwischen Bumps, Dices, Fehlstellen, Lunkern, etc. unterschieden werden. Diese sollten sich durch unterschiedliche Tiefe / Starke / Signalabweichungen auszeichnen. Hier seien alle entsprechenden Algorithmen gemeint, die eine Signalabweichung von der Dicke detektieren können. Mit Vorteil werden diese Auswertealgorithmen auch noch mit geeigneten Algorithmen kombiniert, die beispielsweise auch die flächenmäßige Ausdehnung derartiger Fehlstellen mit berücksichtigen. Die flächenmäßige Ausdehnung der Fehlstellen lässt sich durch eine Auswertung der gesamten gesammelten Dickenwerte im X / Y Koordinatensystem entsprechend der soeben beschriebenen Auswertetechniken ermitteln. Etwaige, nicht gemessene Zwischenwerte sind mit Vorteil durch Interpolation bestimmbar.

Bei Infrarotmessung erfolgt die Messung/Erfassung unabhängig vom Abstand R des Senders 9 / Empfängers 10 von dem Waferstapel 8, da die Messwerte für die Dicken der einzelnen Schichten durch Differenzrechnung basierend auf den Reflexionen an den einzelnen Übergängen erfolgt.

Um die Dickenverteilung der einzelnen zu messenden Schichten über den gesamten Wafer ermitteln zu können, ist es erforderlich, eine Vielzahl von Messpunkten über den Wafer verteilt aufzunehmen. Mit Vorteil sind die Messpunkte in einem geeigneten Koordinatensystem (siehe Figur 10) angeordnet, was später die Analyse und Datenverarbeitung erleichtert. Mit Vorteil korrespondiert das Koordinatensystem für die Messpunkterfassung mit einem lokalen, dem zu inspizierenden Wafer zugeordneten Koordinatensystem. Geeignete Koordinatensystem wären beispielsweise ein kartesisches Koordinatensystem oder ein Polarkoordinatensystem. Mit Vorteil werden die Messpunkte eng genug aneinander gelegt, um typischerweise zu erwartende Defekte (Fehlstellen) mit einer angebrachten Sicherheit zu erfassen. Insbesondere ist es wünschenswert, Defekte von einer Größe, die in den zuvor beschriebenen katastrophalen Fehlerfällen in der nachfolgenden Prozessierung resultieren würden, zu erfassen. Die Schichtenauflösung sollte vorzugsweise besser 10µm, noch bevorzugter besser als 1µm, am bevorzugtesten besser als 0,1µm sein.

Der Durchmesser D des Messsignals gemäß Figur 10 liegt mit Vorteil zwischen 1µm und 100µm, insbesondere zwischen 5µm und 50µm, vorzugsweise zwischen 10µm und 30µm. Bei einem Laserstrahl entspricht der obige Durchmesser D beispielsweise dem Durchmesser des Laserstrahls.

Die Breitenauflösung des Messsignals in lateraler Richtung, also parallel zur Referenzebene R liegt zwischen 0,1µm und 50µm, insbesondere zwischen 1µm und 30µm, vorzugsweise zwischen 10µm und 20µm.

Analog zu dem Vorgehen hinsichtlich Fehlstellen werden mit Vorteil auch die typischerweise auftretenden Wellenlängen der Dickenschwankung beim Festlegen des Messpunkterasters berücksichtigt. Basierend auf den zuvor beschriebenen Überlegungen hat es sich als vorteilhaft erwiesen, etwa alle 1 bis 3 mm einen Messpunkt zu setzen. Um Fehlstellen noch zuverlässiger erkennen zu können, ist es noch idealer, alle 0,8mm oder alle 0,5mm oder noch besser alle 0,25mm einen Messpunkt zu setzen. Für besonders sensible Anwendungen mit sehr geringen Zielwaferdicken kann es auch vorteilhaft sein alle 0,1mm einen Messpunkt zu setzen.

Sehr oft ist es so, dass gewisse elektromagnetische Strahlen, wie beispielsweise Infrarot, nicht in der Lage sind, den Strukturwafer 1 zu durchdringen, da dieser entweder metallisiert, gedoped oder gebumpt ist. Metallisierungen können beispielsweise durch Kontakte 14 an der Oberfläche oder im Inneren des Wafers vorhanden sein. Die Bumps 13 bestehen aus Metalllegierungen, die ebenfalls für IR opak sind. Des Weiteren kann der Wafer gedoped sein. Eine Dotierung kommt vor allem bei Strukturwafern fast immer vor und reduziert die Infrarot-Transparenz.

Mittels eines zusätzlich zu der Messeinrichtung 11 oder in die Messeinrichtung 11 integrierten Interferometers 19 ist die Aufnahmefläche 16 der Aufnahme 12 messbar, bevor der Waferstapel 8 auf die Aufnahme abgelegt wird. In Figur 8 ist eine Oberflächenunebenheit der Aufnahmefläche 16 durch eine Wölbung dargestellt. Die Unregelmäßigkeit der Oberfläche kann aber jede andere Form aufweisen. Dies wird mit dem Weißlichtinterferometer 19 gemessen. Nach Vermessung des Abstandsprofils durch das Weißlichtinterferometer 19 wird der Waferstapel 8 auf die Aufnahme 12 gelegt. Anschließend wird durch das Weißlichtinterferometer 19 erneut gemessen, so dass ein zweites Abstandsprofil, und zwar das des gesamten Waferstapels 8, erhalten wird. Die Differenz beider Abstandsprofile entspricht der Gesamthöhe des Waferstapels 8.

Somit kann in Kombination mit der oben beschriebenen Messung/Erfassung der Übergänge 15, 18 durch entsprechende Berechnung auch die Schichtdicke d3' gemäß Figur 8 ermittelt werden, indem von der Gesamtdicke des Waferstapels 8 die Schichtdicken d1' des Wafers 3 und d2' der Verbindungsschicht 2 abgezogen werden.

Ein weiterer Vorteil ergibt sich durch die Verwendung des Weißlichtinterferometers als Scanner während des Scanprozesses mittels Infrarot. Der Weißlichtinterferometerscanner wird dabei nur entlang einer Linie über den Rand des Waferstapels 8 hinaus bewegt. Er misst dabei kontinuierlich den Abstand zur Oberfläche des Waferstapels 8, wenn er sich über diesem befindet beziehungsweise den Abstand zur Aufnahmefläche 16, wenn er über den Waferstapel 8 hinausfährt. Findet nun während des eigentlichen Infrarotscans eine Höhenänderung des gesamten Systems statt, beispielsweise durch Thermoschwankungen, erfasst der Weißlichtinterferometerscanner diese auf Grund der Höhenschwankung, da absolute Entfernung bestimmbar ist. Im Gegensatz zum Infrarotscanner, welcher mittels Interferenz nur die Peaks misst, welche sich durch Interferenz an den Interfaces 15, 16 und 18 ergeben. Der Infrarotscanner ist also in der Lage, relative Abstände, also Dicken zu messen. Er benötigt immer mindestens zwei Signale, aus deren Differenz die Dicke der jeweiligen Schicht berechnet werden kann. Der Infrarotscanner ist daher unempfindlich gegenüber "Erschütterungen" und Thermoschwankungen. Der Weißlichtinterferometerscanner misst dagegen den Abstand zur Sender-Empfänger-Einheit. Ist seine Scanfrequenz über eine gesamte Scanlinie viel schneller als die Höhenänderung des Gesamtsystems, kann die Höhenänderung des Gesamtsystems als Funktion der Zeit erfasst werden.

Figur 7a zeigt einen mit einer erfindungsgemäßen Messeinrichtung vermessenen Waferstapel 8 mit einem Durchmesser 300mm, bei dem mehrere Fehlstellen 4 mit einer farblich dargestellten Tiefe gefunden wurden. Eine zweidimensionale Auswertung des Waferstapels 8 gemäß Figur 7a ist in Figur 7b in Form eines Diagramms durch die Auswerteeinheit erfolgt, wobei die das Diagramm korrespondierende Linie in Figur 7a eingezeichnet ist. In der Figur 7b ist zu erkennen, wie die Fehlstelle 4 in der Mitte des Waferstapels im Querschnitt aussieht.

In einer weiteren Ausführungsform wird mittels einer der oben vorgestellten Messeinrichtungen die Randzone B des Waferstapels 8 während eines chemischen Behandlungsprozesses in-situ gemessen. Vorzugsweise wird dabei die Messmethode aus Fig. 6c verwendet. Während Chemikalien 22 einen Randzonenkleber 28 der Verbindungsschicht 2 auflösen, ist mittels der Messeinrichtung 11 kontinuierlich der Fortschritt im Lösungsprozess messbar. Mit Vorzug wird die Methode auf Waferstapel 8 angewandt, welche den Strukturwafer und den Trägerwafer nur am Rand bünden. Dem Fachmann auf dem Gebiet sind diese Techniken bekannt.

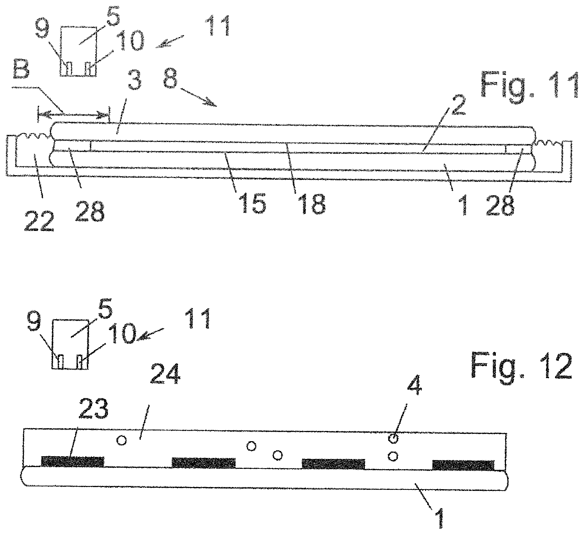

Gemäß einer in Figur 12 gezeigten weiteren Ausführungsform sind mittels einer der vorbeschriebenen Messeinrichtungen Fehlstellen 4 in einer Schicht, insbesondere einem Mold 24, welche elektronische Bauteile 23, insbesondere dices, verdeckt, detektierbar.

Erfindungsgemäß bevorzugte Dopingelemente sind Elemente der dritten Hauptgruppe wie Bor, Indium, Aluminium oder Gallium beziehungsweise Elemente der fünften Hauptgruppe wie Phosphor, Arsen oder Antimon.

### Bezugszeichenliste

- 1: Strukturwafer
- 2: Verbindungsschicht
- 3: Wafer
- 4: Fehlstellen
- 5: Gehäuse
- 6: Membran
- 7: Flüssigkeit
- 8: Waferstapel
- 9: Sender
- 10: Empfänger
- 11: Messeinrichtung
- 12: Aufnahme
- 13: Bumps
- 14: Kontakte
- 15: Übergang
- 16: Aufnahmefläche
- 17: Vakuumbahnen
- 18: Übergang
- 19: Interferometer
- 20: Messsignal
- 21: Überwachungsbereich
- 22: Chemikalien
- 23: Elektronische Bauteile
- 24: Schicht
- 25: Zuleitung
- 26: Membranwand
- 27: Flüssigkeitsreservoir
- 28: Randzonenkleber
- R: Referenzebene
- d1, d1': Schichtdicke
- d2, d2': Schichtdicke
- d3, d3': Schichtdicke
- H: Abstand
- B: Randzone

## Patentansprüche

1. Messeinrichtung zur Messung und/oder Erfassung von Schichtdicken und Fehlstellen einer oder mehrere Schichten eines temporär gebondeten Waferstapels (8) an einer Vielzahl von am Waferstapel (8) verteilten Messstellen mit folgenden Merkmalen:
- einem relativ zum Waferstapel (8) bewegbaren Sender (9) zur Aussendung von Signalen in Form elektromagnetischer Wellen,
- einem mit dem Sender (9) relativ zum Waferstapel (8) bewegbaren Empfänger (10) zum Empfang der vom Sender (9) gesendeten und am Waferstapel (8) reflektierten Signale und
- einem Interferometer zur Messung dessen Abstands zu einer Oberfläche an mindestens einer der Messstellen, **gekennzeichnet durch**
- eine Auswerteeinheit zur Auswertung der vom Empfänger (10) empfangenen Signale, wobei von mindestens zwei Übergängen zwischen Schichten des Waferstapels (8) reflektierte Signale von der Auswerteeinheit unterschieden und deren Abstände zueinander und/oder zu einer Referenzebene (R) ermittelt werden, woraus die Schichtdicken abhängig vom Brechungsindex der Schicht bestimmt werden und auf Fehlstellen mittels des von der Schicht unterschiedlichen Brechungsindex der Fehlstellen rückgeschlossen wird, und wobei eine Bewegung des Waferstapels (8) und/oder der Messeinrichtung (11) parallel zur Referenzebene (R) und damit die Position jeder Messstelle entlang der Referenzebene (R) erfasst wird, wobei das Interferometer als Weißlichtinterferometer ausgebildet ist.

2. Messeinrichtung nach Anspruch 1, bei der das Interferometer mit dem Sender (9) und dem Empfänger (10) mechanisch gekoppelt, vorzugsweise fixiert, ausgebildet ist.

3. Messeinrichtung nach einem der vorhergehenden Ansprüche, bei der der Sender (9) und der Empfänger (10) relativ zum Waferstapel mittels eines Linearantriebs bewegbar sind.

4. Messeinrichtung nach einem der vorhergehenden Ansprüche, bei der der Sender (9) und der Empfänger (10) relativ zum Waferstapel mit einem konstanten Vorschub bei rotierendem Waferstapel (8) zum Zentrum des Waferstapels (8) hin bewegbar sind.

5. Messeinrichtung nach einem der vorhergehenden Ansprüche, bei der der Sender (9) und der Empfänger (10) in einem Gehäuse (5) angeordnet sind.

6. Messeinrichtung nach einem der vorhergehenden Ansprüche, bei der das Interferometer zur Erfassung dessen Abstands zu einer Aufnahmefläche (16) einer Aufnahme (12) ausgebildet ist.

## Claims

1. A measuring device for measuring and/or detecting layer thicknesses and defects of one or more layers of a temporally bonded wafer stack (8) at a plurality of measurement points distributed on the wafer stack (8) with the following features:
- a transmitter (9) movable relative to the wafer stack (8) for transmitting signals in the form of electromagnetic waves,
- a receiver (10) movable with the transmitter (9) relative to the wafer stack (8) for receiving the signals sent by the transmitter (9) and reflected at the wafer stack (8) and
- an interferometer for measuring its distance from a surface at at least one of the measurement points, **characterised by**
- an evaluation unit for evaluating the signals received by the receiver (10), wherein signals reflected from at least two transitions between layers of the wafer stack (8) are distinguished by the evaluation unit and their distances from one another and/or from a reference plane (R) are determined, from which the layer thicknesses are determined depending on the refractive index of the layer and defects are deduced by means of the refractive index of the defective points differing from the layer, and wherein a movement of the wafer stack (8) and/or the measuring device (11) parallel to the reference plane (R) and therefore the position of each measurement point along the reference plane (R) is detected, wherein the interferometer is constituted as a white light interferometer.

2. The measuring device according to claim 1, wherein the interferometer is mechanically coupled with, preferably fixed to, the transmitter (9) and the receiver (10).

3. The measuring device according to any one of the preceding claims, wherein the transmitter (9) and the receiver (10) can be moved relative to the wafer stack by means of a linear drive.

4. The measuring device according to any one of the preceding claims, wherein the transmitter (9) and the receiver (10) can be moved relative to the wafer stack with a constant advance with a rotating stack (8) towards the centre of the wafer stack (8).

5. The measuring device according to any one of the preceding claims, wherein the transmitter (9) and the receiver (10) are arranged in a housing (5).

6. The measuring device according to any one of the preceding claims, wherein the interferometer is designed for the detection of its distance from the mounting surface (16) of a mount (12).

## Revendications

1. Dispositif de mesure pour la mesure et/ou la détection d'épaisseurs de couche et de points défectueux d'une ou plusieurs couches d'une pile de plaquettes liées temporairement (8) à de multiples points de mesure répartis sur la pile de plaquettes (8), présentant les caractéristiques suivantes :
- un émetteur (9) mobile par rapport à la pile de plaquettes (8) pour l'envoi de signaux sous la forme d'ondes électromagnétiques,
- un récepteur (10) mobile avec l'émetteur (9) par rapport à la pile de plaquettes (8) pour la réception des signaux envoyés par l'émetteur (9) et réfléchis par la pile de plaquettes (8),
- un interféromètre pour la mesure de sa distance par rapport à une surface à au moins un des points de mesure, **caractérisé par**
- une unité d'exploitation pour l'exploitation des signaux reçus par le récepteur (10), les signaux réfléchis par au moins deux transitions entre des couches de la pile de plaquettes (8) étant différenciés par l'unité d'exploitation et leurs distances les uns par rapport aux autres et/ou par rapport à un plan de référence (R) étant déterminée, à partir de quoi les épaisseurs de couche étant définies en fonction de l'indice de réfraction de la couche et la présence de points défectueux étant déduite au moyen de l'indice de réfraction différent des points défectueux, et un mouvement de la pile de plaquettes (8) et/ou
du dispositif de mesure (11) parallèlement au plan de référence (R) et ainsi la position de chaque point de mesure le long du plan de référence (R) étant détectée, l'interféromètre se présentant sous forme d'un interféromètre à lumière blanche.

2. Dispositif de mesure selon la revendication 1, dans lequel l'interféromètre est conçu pour à être couplé, de préférence fixé, mécaniquement à l'émetteur (9) et au récepteur (10).

3. Dispositif de mesure selon l'une quelconque des revendications précédentes, dans lequel l'émetteur (9) et le récepteur (10) sont mobiles par rapport à la pile de plaquettes au moyen d'une commande linéaire.

4. Dispositif de mesure selon l'une quelconque des revendications précédentes, dans lequel l'émetteur (9) et le récepteur (10) sont mobiles par rapport à la pile de plaquettes avec une avance constante, lors de la rotation de la pile de plaquettes (8), vers le centre de la pile de plaquettes (8).

5. Dispositif de mesure selon l'une quelconque des revendications précédentes, dans lequel l'émetteur (9) et le récepteur (10) sont disposés dans un boîtier (5)

6. Dispositif de mesure selon l'une quelconque des revendications précédentes, dans lequel l'interféromètre est conçu pour détecter sa distance par rapport à une surface d'appui (16) d'un support (12).
